# EUROPÄISCHE PATENTANMELDUNG

(11) **EP 2 261 185 A2**
(43) Veröffentlichungstag der Anmeldung: **15.12.2010**
(21) Anmeldenummer: 10010428.0
(22) Anmeldetag: 03.11.2005
(51) Int. Cl.: C03C 17/245, C03C 17/34, C23C 16/453

(54) **Solarglas-Scheibe mit Barierrebeschichtung und Verfahren zur Herstellung einer Solarglas-Scheibe**

(30) Priorität: 03.11.2004 DE 102004053706
(62) Teilanmeldung aus: 05802295.5
(71) Anmelder: SCHOTT AG, 55122 Mainz (DE)
(72) Erfinder: Henze, Inka, Dr., 55288 Udenheim (DE); Gudgel, Todd, Dr., 55270 Jugenheim (DE); Weber, Gerhard, 55234 Beckenheim (DE); Luther, Veit, 65795 Hattersheim (DE); Schultheis, Bernd, 55270 Schwabenheim (DE)
(74) Vertreter: Blumbach - Zinngrebe

(57) **Zusammenfassung**

Um Barrierebeschichtungen auch ohne den Einsatz von Vakuumbeschichtungsanlagen und ohne die sich dadurch ergebenden Einschränkungen hinsichtlich der Wahl der Substratmaterialien und Substratabmessungen bereitstellen zu können, sieht die Erfindung einen Gegenstand mit einem Glassubstrat (1) und einer darauf angeordneten Barrierebeschichtung vor, bei welchem die Barrierebeschichtung eine flammpyrolytische Metalloxid-haltige Schicht (5) umfaßt. Auf die Barriereschicht ist eine Antireflex-Schicht aufgebracht.

## Beschreibung

Die Erfindung betrifft eine Solarglas-Scheibe mit Barriere- oder Sperrschicht und die Herstellung einer Solarglas-Scheibe.

Barriere- oder Sperrbeschichtungen von Gegenständen werden allgemein zur Versiegelung von Oberflächen, insbesondere zur Verhinderung oder Verlangsamung des Hindurchtretens von Atomen und Molekülen aus und in die Umgebung der Oberfläche eingesetzt. Entsprechend vielfältig sind die Anwendungen für derartige Beschichtungen. So werden Barriereschichten zum Beispiel bei Lebensmittelverpackungen eingesetzt, um eine möglichst hermetische Versiegelung der verpackten Nahrungsmittel und eine Verlängerung der Haltbarkeit zu erreichen.

Zur Herstellung dünner Sperrschichten kommen vielfach Vakuum- oder Niederdruck-Abscheideverfahren, wie Plasma-Deposition, Aufdampfen oder Sputterbeschichtung zum Einsatz. Diese Verfahren sind jedoch aufgrund der notwendigen Evakuierung kostenintensiv. Außerdem sind diese Verfahren auch nicht für jedes Substrat geeignet. Unter anderem ergeben sich Schwierigkeiten bei großformatigen Substraten, für die entsprechend große Vakuumkammern bereitgestellt werden müssten. Auch können Substrate, die im Vakuum stark ausgasen oder aufgrund von eingeschlossenen Gasmengen der mechanischen Belastung bei der Evakuierung nicht gewachsen sind, im allgemeinen nicht mit diesen Verfahren beschichtet werden.

Andererseits weisen die mit diesen Verfahren herstellbaren Beschichtungen auch bei sehr geringen Schichtdicken im Nanometer- oder Mikrometer-Bereich bereits sehr hohe Barrierewirkungen auf.

Aus der US 5,165,972 ist eine Barrierebeschichtung auf Glas bekannt, mit welchen die Migration von Alkali-Ionen von der Glasoberfläche verhindert werden soll. Die Beschichtung wird mittels Pyrolyse eines Silan-Gases auf der auf mehr als 600 °C erhitzten Glasoberfläche in Verbindung mit einer gasförmigen Elektronen-Donator-Verbindung erzeugt, wobei Sauerstoff aus der Glasoberfläche an der Bildung der Schicht beteiligt ist. Dieses Verfahren erfordert allerdings sehr heiße Substratoberflächen und ist daher ebenfalls für eine Vielzahl von Substraten, die nicht hinreichend temperaturstabil sind, nicht geeignet.

Es besteht daher Bedarf, Barrierebeschichtungen mit zumindest vergleichbaren Eigenschaften auch ohne den Einsatz von Vakuumbeschichtungsanlagen und ohne die sich dadurch oder bei der Pyrolyse auf heißen Oberflächen ergebenden Einschränkungen hinsichtlich der Wahl der Substratmaterialien und Substratabmessungen verwenden und herstellen zu können.

Diese Aufgabe wird bereits in höchst überraschend einfacher Weise durch eine Solarglas-Scheibe und ein Verfahren zu deren Herstellung gemäß den unabhängigen Ansprüchen gelöst. Vorteilhafte Ausgestaltungen und Weiterbildungen sind Gegenstand der jeweiligen Unteransprüche.

Demgemäß sieht die Erfindung eine Solarglas-Scheibe mit einem Substrat und einer darauf angeordneten Barrierebeschichtung vor, wobei die Barrierebeschichtung eine flammpyrolytisch aufgebrachte Metalloxid-haltige Schicht umfaßt. Weiter umfasst die Solarglas-Scheibe eine Antireflex-Schicht, wobei die Antireflex-Schicht vorzugsweise auf der Barrierebeschichtung aufgebracht ist. Ein derartiges Erzeugnis ist erfindungsgemäß mit einem Verfahren zur Herstellung einer Solarglas-Scheibemit einer Barrierebeschichtung auf einem Substrat herstellbar, bei welchem zumindest ein Bereich der Oberfläche des Substrats mit einer Flamme überstrichen und eine metalloxidhaltige Schicht mittels Hydrolyse einer metallhaltigen Verbindung in der Flamme abgeschieden wird, während die Flamme den Bereich des Substrats überstreicht.

Im Unterschied zu dem aus der US 5,165,972 bekannten Verfahren findet eine Hydrolyse der metallhaltigen Verbindung bereits in der Flamme statt. Die Flamme kann das Substrat dabei sehr schnell überstreichen, so daß sich das Substrat nur unwesentlich erwärmt. Aufgrund der Hydrolyse in der Flamme wird eine Veränderung der Stöchiometrie der Substratoberfläche durch Einbindung von Sauerstoff, wie sie sich aus dem aus der US 5,165,972 bekannten Verfahren unter Sauerstoffausschluß ergibt, außerdem weitgehend vermieden.

Mittels der Erfindung können Barrierebeschichtungen hergestellt werden, welche in ihren Barriereeigenschaften zumindest vergleichbar zu aufgesputterten oder mittels Plasmabeschichtung abgeschiedenen Barriereschichten sind.
Im Unterschied zu diesen bekannten Verfahren zur Herstellung von Barriereschichten ist erfindungsgemäß aber keine Evakuierung der Umgebung des zu beschichtenden Substrats nötig. Die für Vakuumbeschichtungsverfahren, wie Sputtern, Aufdampfen oder plasmainduzierte Dampfphasenabscheidung notwendige Evakuierung ist aber ein wesentlicher Kostenfaktor, der bei der erfindungsgemäßen Beschichtung entfallen kann. Auch können erfindungsgemäß beispielsweise sehr großflächige Substrate problemlos mit einer Barrierebeschichtung versehen werden, die ansonsten in einer entsprechend großvolumigen und damit teuren Vakuumbeschichtungsanlage aufgebracht werden müßten.

Von den mit Vakuumabscheideverfahren abgeschiedenen Schichten unterscheiden sich die erfindungsgemäßen flammpyrolytisch aufgebrachten, beziehungsweise abgeschiedenen Schichten im allgemeinen bereits dadurch, daß die flammpyrolytischen Schichten OH-Gruppen aufweisen. Insbesondere befinden sich solche Hydroxylgruppen auch an der Oberfläche der Schicht. Damit wird neben einer für die Barriereeigenschaften dichten Struktur außerdem noch eine Oberfläche mit einer hohen Oberflächenenergie und funktionellen Gruppen geschaffen, die eine gute Anbindung weiterer Moleküle erlauben. Dementsprechend eignen sich die erfindungsgemäßen Schichten unter anderem gleichzeitig noch besonders gut für eine Weiterverarbeitung, wie etwa für das Aufbringen weiterer Beschichtungen, die auf den erfindungsgemäßen Schichten besonders gut haften.

Durch die hohe Oberflächenenergie wird außerdem auch eine wirkungsvolle Antibeschlag-Wirkung erzeugt.

Gemäß einer bevorzugten Ausführungsform der Erfindung wird eine silikathaltige flammpyrolytisch aufgebrachte Schicht hergestellt. Eine derartige Schicht kann hergestellt werden, indem eine silikathaltige Schicht durch Hydrolyse einer Siliziumverbindung in der Flamme abgeschieden wird. Geeignete Siliziumverbindungen dazu sind unter anderem Hexamethyldisiloxan (HMDSO), Hexamethyldisilazan (HMDSN), Tetramethoxysilan, Tetraethoxysilan.

Zusätzlich oder alternativ können der flammpyrolytischen, beziehungsweise flammpyrolytisch aufgebrachten Schicht vorteilhafte funktionelle Eigenschaften verliehen werden, wenn die flammpyrolytische Schicht ein Oxid zumindest eines der Metalle Titan, Aluminium, Zirkonium, Zinn, Indium enthält, indem bei der Abscheidung der Schicht in der Flamme eine Verbindung eines der Metalle Titan, Aluminium, Zirkonium, Zinn, Indium hydrolysiert wird. Diese Metalloxide können, auch in Verbindung mit Siliziumoxid, beziehungsweise Silikat in der flammpyrolytischen Schicht, auch gemischt vorliegen. Aus Mischungen von derartigen Metalloxiden, beziehungsweise, können beispielsweise sehr harte und/oder feuchtebeständige und/oder leitfähige Schichten erzeugt werden. Als Mischung wird im Sinne der Erfindung auch eine Dotierung verstanden. So kann unter anderem eine silikathaltige flammpyrolytische Schicht mit einem anderen Metalloxid, beispielsweise einem oder mehreren Oxiden der vorgenannten Metalle, dotiert werden, um zusätzliche funktionelle Eigenschaften zu erhalten und/oder die Barriereeigenschaften der flammpyrolytischen Schicht zu verbessern. So eignet sich beispielsweise Zinnoxid als wärmereflektierende Schicht.

Eine erfindungsgemäße flammpyrolytische Schicht kann auch ein mit anderen Materialien gemischtes oder dotiertes Metalloxid enthalten. Ein vorteilhaftes Beispiel für eine flammpyrolytisch abgeschiedene Schicht mit zusätzlichen funktionellen Eigenschaften ist eine Zinnoxid-haltige flammpyrolytische Schicht, welche mit Fluor und/oder Indium dotiert ist. Eine derartige Schicht eignet sich beispielsweise als leitfähige transparente Schicht oder zu ihren wärmereflektierenden Eigenschaften auch zur Reduzierung der statischen Aufladung von Oberflächen .

Verschiedene flammpyrolytisch abgeschiedene Oxide können nicht nur in einer Schicht miteinander gemischt werden. Es ist gemäß einer Weiterbildung der Erfindung auch daran gedacht, eine mehrlagige flammpyrolytische Schicht abzuscheiden. Durch einen mehrschichtigen oder mehrlagigen Aufbau können unter anderem optische Effekte, wie beispielsweise Ver- oder Entspiegelungen und/oder Farbortverschiebungen erreich werden. Selbstverständlich kann auch das Verfahren der Abscheidung mittels der flammpyrolytischen Beschichtung auch mit anderen Beschichtungsverfahren kombiniert werden, um eine mehrlagige Funktionalschicht zu erhalten.

Sogar eine Gradientenschicht mit kontinuierlich variierender Zusammensetzung in Richtung senkrecht zur Oberfläche kann erfindungsgemäß flammpyrolytisch abgeschieden werden. Flammpyrolytische Schichten mit einer Mischung verschiedener Oxide können beispielsweise durch Überstreichen des Substrats mit einer Flamme und Abscheiden einer metalloxidhaltigen Schicht mittels Hydrolyse mehrerer metallhaltiger Verbindungen in der Flamme abgeschieden werden. Auch kann die Oberfläche sequentiell mit Flammen überstrichen werden, denen jeweils unterschiedliche metallhaltige Verbindungen zugeführt werden, um eine flammpyrolytische Beschichtung abzuscheiden, die verschiedene Oxide enthält. Letzteres Verfahren eignet sich insbesondere auch zur Abscheidung mehrlagiger flammpyrolytischer Schichten. Ein sequentielles Überstreichen der Oberfläche kann beispielsweise mittels mehrerer hintereinander angeordneter Brenner erreicht werden, an welchen das Substrat vorbeibewegt wird, und/oder mit welchen das Substrat überstrichen wird.

Eine Kombination von Eigenschaften lässt sich durch eine Mischung von Precursor-Gasen über eine Flamme oder durch mehrere Flammen hintereinander angeordnet mit unterschiedlichen geeigneten Metalloxid-haltigen Verbindungen erreichen. Aus Mischungen von Metalloxiden, z.B. mit Metallen wie Si, Ti, Al, Zr, Sn, In, Sb können beispielsweise sehr harte und/oder feuchtebeständige und/oder leitfähige Schichten erzeugt werden.

Bevorzugt wird weiterhin ein Methan, Propan- oder Butan enthaltendes Brenngas zur Erzeugung der Flamme verwendet. Diese Gase sind als Brenngas vergleichsweise kostengünstig und erzeugen ausreichende Flammentemperaturen. Die Verbrennung kann an Luft oder mittels separat zugeführtem Sauerstoff erfolgen.

Um eine möglichst vollständige Hydrolyse der metallhaltigen Verbindung in der Flamme zu erreichen, hat es sich weiterhin als vorteilhaft erwiesen, wenn eine Flamme mit einem oxidierenden und einem reduzierenden Teil erzeugt und das Substrat nur mit dem oxidierenden Teil überstrichen wird. Eine weitere Maßnahme ist, ein eine reduzierende Komponente, vorzugsweise Wasserstoff oder Kohlenmonoxid enthaltendes Brenngas zur Erzeugung der Flamme zu verwenden.

Es hat sich überraschend gezeigt, daß bereits sehr dünne flammpyrolytische Schichten gute Barriereeigenschaften aufweisen. So weisen bereits Schichtdicken einer erfindungsgemäß flammpyrolytisch abgeschiedenen Barrierebeschichtung von 1 bis 100 Nanometern, bevorzugt 4 bis 40 Nanometern, oder sogar von höchstens 20 Nanometern sehr gute Barrierewirkungen auf.

Weiterhin zeigt sich, daß mit der flammpyrolytischen Abscheidung eine körnige Oberflächenstruktur mit Körnern auf der Oberfläche der abgeschiedenen Schicht mit einem in Aufsicht betrachteten Durchmesser bis höchstens 80 Nanometer, vorzugsweise bis höchstens 60 Nanometer erzeugt werden kann. Dabei sind die Körner auf der Oberfläche einer dichten flammpyrolytischen Schicht angeordnet. Bei einer solchen Schicht wird als Schichtdicke die Schichtdicke der dichten Schicht ohne den darauf angeordneten Körnern verstanden.

Eine derartige Schichtstruktur wurde insbesondere bei einer Siliziumoxid-haltigen Schicht gefunden. Es wird dabei nicht ausgeschlossen, daß sich auch einzelne Körner mit noch größeren Durchmessern auf der Oberfläche finden. Beispielsweise kann es zu einer Agglomeration mehrerer Körner kommen, welche im Mikroskop dann unter Umständen wie ein einzelnes Korn erscheinen können. Jedenfalls weisen bei erfindungsgemäßen Schichten gemäß dieser Ausführungsform der Erfindung mehr als 90% der bei 200000-facher Vergrößerung im Rasterelektronenmikroskop erkennbaren Körner einem Durchmesser bis höchstens 80 Nanometer, vorzugsweise bis höchstens 60 Nanometer auf. Im allgemeinen weisen die Körner überwiegend Durchmesser bis 40 Nanometer auf. Auch können sich größere Körner mit größerem Durchmesser erkennbar aus solchen kleineren, agglomerierten Körnern zusammensetzen. Diese Schichten ermöglichen unter anderem eine besonders gut haftende Beschichtung mit weiteren Schichten, da durch die körnige Struktur einer derart abgeschiedenen Schicht eine sehr große Oberfläche erreicht werden kann. Außerdem kann die Empfindlichkeit gegen ein Verkratzen herabgesetzt werden.

Gemäß einer Ausführungsform der Erfindung ist vorgesehen, ein Glas- oder Glaskeramiksubstrat mit der flammpyrolytischen Beschichtung zu versehen. Obwohl Glas oder Glaskeramik selbst im allgemeinen bereits gute Barriereeigenschaften aufweist, kann eine erfindungsgemäße zusätzliche Barrierebeschichtung überraschend dennoch die Produkteigenschaften verbessern. Als Barrierebeschichtung auf Glas- oder Glaskeramik ist es insbesondere möglich, die Diffusion von Ionen oder Molekülen aus oder in das Substrat zu verhindern. Beispielsweise kann es beim Tempern oder allgemein einer Erhitzung des Substrats zu einer unerwünschten Diffusion von Substratkomponenten aus dem Substrat oder auch von Komponenten weiterer darauf aufgebrachter Beschichtungen kommen.

Eine weitere Anwendung ist der Korrosionsschutz von Glas- oder Glaskeramik-Artikeln gegenüber aggressiven Gasen und/oder Verbrennungsprodukten. Die Erfindung eignet sich dementsprechend hervorragend auch für gasbeheizte Glaskeramik-Kochfelder, die insbesondere einem direkten Kontakt mit schwefelhaltigen Brenngasen ausgesetzt sind.

Noch eine weitere bevorzugte Anwendung ist eine erfindungsgemäße flammpyrolytische Barrierebeschichtung auf Kalknatronglas, um die Diffusion von Alkalien aus dem Glas zu verhindern. Unerwünschte Wechselwirkungen von Alkalien mit Medikamenten oder weiteren funktionellen Schichten können so wirkungsvoll und in überraschend einfacher Weise vermindert werden.

Allgemein bewirkt eine derartige flammpyrolytische Sperr- oder Barriereschicht auch eine Versiegelung einer Substrat- oder Schichtoberfläche gegen Wechselwirkung mit Verdampfungskomponenten und/oder Partikel aus einer "Temperumgebung", also bei einem Einsatz des Gegenstands bei hohen Temperaturen. Die erfindungsgemäße Beschichtung bietet Schutz vor einer Degradation von Solargläsern. Als Solargläser werden im Sinne der Erfindung Gläser bezeichnet, die in Solaranlagen -sowohl solarthermische als auch photovoltaische Anlagen- eingesetzt werden.

Überraschend können nicht nur vergleichsweise temperaturbeständige Substrate, wie unter anderem die erwähnten Glas- oder Glaskeramik-Substrate beschichtet werden. Es ist auch möglich, Metall- oder Kunststoffsubstrate zu beschichten. Sogar Kunststofffolien können ohne eine Beschädigung durch die Flammbeaufschlagung zur Abscheidung der flammpyrolytischen Schicht mit einer Barrierebeschichtung versehen werden.

Ähnlich wie bei der Herstellung von Glaskeramik kann eine erfindungsgemäße flammpyrolytische Beschichtung als hochschmelzende Schicht auch bei Kunststoffsubstraten bei nachfolgenden Verarbeitungsschritten -gedacht ist hier insbesondere an die Heißformgebung- das Ankleben an Unterlagen oder Formen verhindern.

Eine Weiterbildung der Erfindung sieht vor, daß dem Brenngas eine metallorganische Verbindung zugesetzt wird, welches durch Hydrolyse ein leitendes oder halbleitendes Oxid ergibt. Damit kann eine flammpyrolytische Schicht erzeugt werden, welche ein leitendes oder halbleitendes Oxid enthält. Derartige Schichten, beispielsweise in Form einer Silikat-, beziehungsweise Siliziumoxidschicht, welche ein halbleitendes oder leitendes Oxid enthält, können zusätzlich zu einer Barrierewirkung auch zur Vermeidung statischer Aufladungen dienen. Beispielsweise kann eine flammpyrolytische Schicht abgeschieden werden, die Zinnoxid enthält. Dazu kann dem Brenngas entsprechend eine zinnhaltige Verbindung, beispielsweise Zinnchlorid oder eine Zinn enthaltende organische Substanz zugesetzt werden.

Die Eigenschaften und Einsatzmöglichkeiten erfindungsgemäß herstellbarer Gegenstände können auch durch weitere funktionelle Schichten vorteilhaft erweitert werden. So kann vorteilhaft zumindest eine weitere funktionelle Schicht aufgebracht werden, welche , wenigstens einer der Eigenschaften -elektrisch leitend, -Infrarotreflektierend, -Kratzschutz, -Antireflex, -Verspiegelung, - photokatalytisch, -Farbgebend, -antimikrobiell aufweist. Die funktionelle Schicht kann auf der flammpyrolytischen Barriereschicht, oder die flammpyrolytische Barriereschicht auf der weiteren funktionellen Schicht aufgebracht werden.

Ein weiteres vorteilhaftes Beispiel für eine funktionelle Schicht ist eine Indium-Zinn-Oxidschicht. Derartige Schichten werden vielfach als transparente leitfähige Schichten eingesetzt. In Kombination mit einer solchen transparenten leitfähigen Schicht ergibt sich außerdem ein weiterer Vorteil der Erfindung. Indium-Zinn-Oxid (ITO) zeigt schlechte Hafteigenschaften, welche sich sowohl in einer schlechten Haftung des ITO auf dem Substrat, als auch in einer schlechten Haftung von auf einer ITO-Schicht aufgebrachten Schichten äußert. Durch die Eigenschaft der erfindungsgemäßen flammpyrolytischen Schicht, aufgrund der vorhandenen Hydroxylgruppen eine gute Anbindung zu bewirken, kann die flammpyrolytische Barrierebeschichtung gleichzeitig als Haftvermittler für die ITO-Schicht dienen. Wird eine flammpyrolytische Barriereschicht vor der ITO-Schicht auf dem Substrat abgeschieden, so ergibt sich eine verbesserte Haftung des darauf aufgebrachten ITO. Ebenso kann eine bessere Haftung nachfolgender Schichten auf eine mit ITO beschichteten Substrat erreicht werden, wenn vorher eine flammpyrolytische Barriereschicht als Haftvermittler abgeschieden wird.

Eine weitere Ausführungsform der Erfindung sieht vor, daß das Substrat mit einer hydrophoben Beschichung beschichtet wird. Gemäß einer bevorzugten Weiterbildung wird dazu eine Silikat-haltige Schicht mit einer hydrophoben Komponente, insbesondere eine Fluorverbindung, bevorzugt Fluoralkylsilan verwendet. Es hat sich insbesondere auch hier als besonders vorteilhaft erwiesen, wenn die hydrophoben Beschichung auf der flammpyrolytischen Beschichtung aufgebracht wird. Eine derartige Schichtanordnung führt zu besonders beständigen hydrophoben Schichten. Derartige Beschichtungen können beispielsweise leicht reinigbare Oberflächen schaffen.

Das Aufbringen der hydrophoben Beschichtung umfaßt demgemäß in bevorzugter Weiterbildung auch das Aufbringen eines Silikat-haltigen Sol-Gels auf der flammpyrolytischen Schicht, wobei das Sol-Gel eine hydrophoben Komponente, insbesondere eine Fluorverbindung, bevorzugt Fluoralkylsilan enthält.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können.

Es zeigen:
- Fig. 1: eine Anordnung und ein Verfahren gemäß eines Ausführungsbeispiels zur Herstellung eines erfindungsgemäßen flammpyrolytisch beschichteten Gegenstands,
- Fig. 2: Ausführungsbeispiele eines erfindungsgemäßen Gegenstands mit Indium-Zinn-Oxidschicht und hydrophober Beschichtung,
- Fig. 3: ein Ausführungsbeispiel mit mehrlagiger flammpyrolytischer Beschichtung,
- Fig. 4: eine Solaranlage mit erfindungsgemäß beschichtetem Solarglas, und
- Fig. 5 und 6: rasterelektronenmikroskopische Aufnahmen einer flammpyrolytisch abgeschiedenen Barriereschicht.

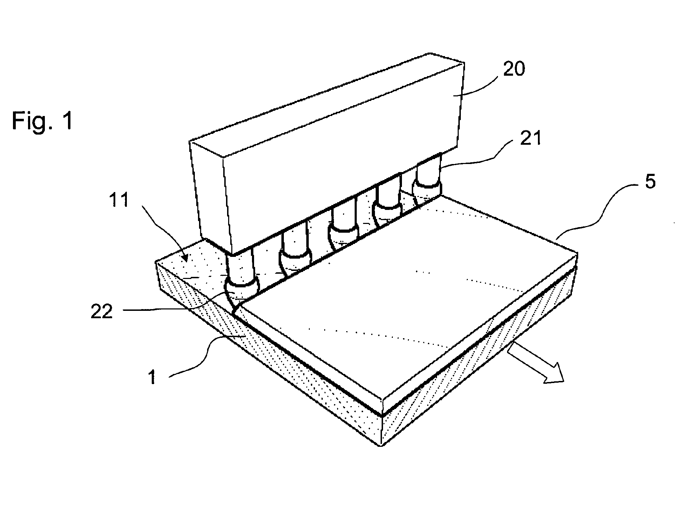

Fig. 1 zeigt eine Anordnung mit welcher gemäß der Erfindung ein Gegenstand mit flammpyrolytischer Barrierebeschichtung herstellbar ist. Die Herstellung erfindungsgemäßer Gegenstände mit einer Barrierebeschichtung auf einem Substrat basiert darauf, daß zumindest ein Bereich der Oberfläche des Substrats mit einer Flamme überstrichen und eine metalloxidhaltige Schicht mittels Hydrolyse einer metallhaltigen Verbindung in der Flamme abgeschieden wird, während die Flamme den Bereich des Substrats überstreicht.

Zur Herstellung des Gegenstands wird ein flaches, scheibenförmiges Glassubstrat bereitgestellt. Als Substrat 1 kann, wie bei dem in Fig. 1 gezeigten Ausführungsbeispiel eine Glasscheibe aus Floatglas, gewalztem oder gezogenem Glas verwendet werden, welche durch Abtrennen eines Abschnitts von einem kontinuierlich hergestellten gefloateten und/oder gewalzten Glasband hergestellt wird. Zur Abscheidung der flammpyrolytischen, Metalloxid-haltigen Schicht 5 wird die Seite 11 des in diesem Beispiel flachen, scheibenförmigen Substrats 1 dann mit Flammen 22 überstrichen, indem das Substrat 1 an einer Brennerbatterie 20 mit Brennern 21, welche die Flammen 22 erzeugen, vorbeigeführt wird. Selbstverständlich ist es auch möglich, anstelle oder zusätzlich zur Bewegung des Substrats 1 die Brennerbatterie 20 zu bewegen.

Das Metalloxid der flammpyrolytischen Schicht 5 kann insbesondere Siliziumoxid, beziehungsweise Silikat sein oder Silikat, beziehungsweise Siliziumoxid umfassen. Dazu wird den Flammen eine Siliziumverbindung zugeführt. Bevorzugt erfolgt die Zuführung durch Beimischung einer gasförmigen oder verdampfbaren Siliziumverbindung zum Brenngas. Als Brenngas wird bevorzugt ein Gas mit einer oder mehreren der Komponenten Wasserstoff, Methan, Propan, Butan eingesetzt. Die Verbrennung erfolgt an Luft. Alternativ oder zusätzlich kann auch Sauerstoff zugeführt werden.

Durch die Hydrolyse der Siliziumverbindung in den Flammen 21 wird auf dem Substrat 1 dann eine flammpyrolytische silikathaltige Schicht 5 abgeschieden. Als Siliziumverbindung kann insbesondere Hexamethyldisiloxan (HMDSO), Hexamethyldisilazan (HMDSN) und/oder Tetraethoxysilan der Flamme zugeführt werden. Bevorzugt werden Silane, wie Tetraethoxysilan eingesetzt.

Alternativ oder zusätzlich -je nachdem, welche funktionellen Eigenschaften die Schicht 5 erhalten soll, können auch eine oder mehrere Verbindungen mit den Metallen Titan, Aluminium, Zirkonium, Zinn, Indium den Flammen 22 zugesetzt werden, um durch Hydrolyse dieser Verbindungen Metalloxide dieser Metalle zu erhalten. Auch können auf diese Weise Mischoxide abgeschieden werden, wie etwa silikathaltige Schichten, welche mit einem oder mehreren Oxiden der Metalle Titan, Aluminium, Zirkonium, Zinn, Indium dotiert sind.

Die Beschichtung mit verschiedenen Oxiden kann auch sequentiell erfolgen. Dazu kann das Substrat 1 mehrmals mit den Flammen 22 der Brennerbatterie 20 überstrichen werden, wobei jeweils andere metallhaltige Verbindungen zugesetzt und hydrolysiert werden. Auch können dazu mehrere Brennerbatterien hintereinander angeordnet werden, wobei in den jeweiligen Brennern der Brennerbatterien verschiedene Metalloxide hydrolysiert werden.

Es hat sich als bei der Beschichtung außerdem als vorteilhaft erwiesen, Flammen mit einem oxidierenden und einem reduzierenden Teil zu erzeugen und das Substrat nur mit dem oxidierenden Teil zu überstreichen. Damit wird eine möglichst vollständige Hydrolyse erreicht und die Einlagerung unvollständig verbrannter Brenngasbestandteile, wie beispielsweise von Kohlenwasserstoffen vermieden. Auch können dem Brenngas zur Unterstützung der Hydrolyse reduzierende Komponenten, wie Wasserstoff oder Kohlenmonoxid beigemischt werden.

Die für die Schichtdicke der Schicht 5 relevanten Beschichtungsparameter, wie unter anderem die Zusammensetzung des Brenngases mit Siliziumverbindung und die Geschwindigkeit des Vorbeiführens des Substrats 1 an den Flammen 22 werden so eingestellt, daß die flammpyrolytische Schicht 5 eine Schichtdicke von 1 bis 100 Nanometern, bevorzugt 4 bis 40 Nanometern, besonders bevorzugt höchstens 20 Nanometern aufweist. Selbst mit Schichtdicken unter 20 Nanometern kann in vielen Fällen noch eine ausreichende Barrierewirkung der Schicht 5 erzielt werden.

Die erfindungsgemäße flammpyrolytische Schicht 5 kann außerdem die Stoßfestigkeit verbessern. Wird die Schicht 5 vor dem Keramisieren des Ausgangsglases aufgebracht, so kann ein Ankleben der Glasplatte beim Keramisieren auf der Keramisierungsunterlage vermieden werden. Damit werden auch Kratzer, die durch ein Ankleben, Schrumpfen und dadurch verursachten Ablösen der beim Keramisieren sehr weichen Platte von der Unterlage entstehen, vermieden. Da diese Kratzer die Stoßfestigkeit der fertig keramisierten Platte herabsetzen, kann eine verbesserte Festigkeit erzielt werden.

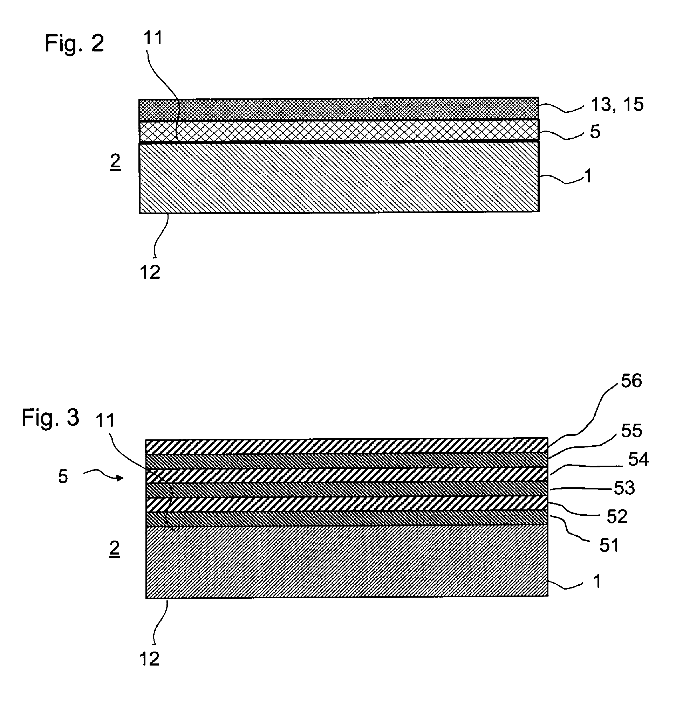

Anhand von Fig. 2 werden zwei weitere Ausführungsbeispiele hergestellter Gegenstände 2 erläutert. Bei beiden Ausführungsbeispielen ist zunächst auf einer Seite 11 eines Substrats 1 eine silikathaltige flammpyrolytische Barriereschicht 5 durch Beflammung der Seite 11 mit einer oder mehreren Flammen und Hydrolyse einer Siliziumverbindung, vorzugsweise eines Silans in der Flamme abgeschieden worden.

Gemäß einem ersten Ausführungsbeispiel ist auf dieser Schicht 5 eine Indium-Zinn-Oxidschicht 13 abgeschieden worden. Das Abscheiden dieser Schicht 13 kann beispielsweise durch Sputtern erfolgen. Neben einer Barrierewirkung aufgrund der dichten Struktur der Schicht 5 wird außerdem eine Verbesserung der Hafteigenschaften der ITO-Schicht 13 erzielt, da die Schicht 5 an ihrer Oberfläche Hydroxylgruppen aufweist, mit welchen eine gute Bindung an das ITO erreicht wird. Aufgrund der guten Sperrwirkung der Schicht 5 und der Haftungsverbesserung kann das Substrat 1 beispielsweise auch ein Kunststoffsubstrat sein. Auch hier zeigen sich besondere Vorteile einer erfindungsgemäßen flammpyrolytischen Beschichtung, da insbesondere auf Kunststoff ITO ansonsten nur sehr schlecht haftet. Die meisten Kunststoffe haben überdies im allgemeinen nur schlechte Barriereeigenschaften, so daß die Schicht 5 hier zusätzlich einen wirksamen Schutz gegenüber durch das Substrat 1 hindurchdiffundierenden Bestandteilen, wie Wasser oder Sauerstoff bereitstellt.

Es ist außerdem daran gedacht, auch die Indium-Zinn-Oxidschicht 13 flammpyrolytisch abzuscheiden. Dazu kann die Seite 11 des Substrats 1 sequentiell mit Flammen überstrichen werden, wobei die silikathaltige Schicht 5 durch Zusatz einer Siliziumverbindung, beispielsweise ein Silan, zur Flamme zugesetzt und dann durch Überstreichen mit einer oder mehreren weiteren Flammen, denen Indium- und Zinnverbindungen zugesetzt werden, die Indium-Zinn-Oxidschicht 13 abgeschieden wird. Auf diese Weise wird dementsprechend eine mehrlagige flammpyrolytische Beschichtung erhalten. Eine Alternative zu einer derartigen Schicht 13 ist eine Fluor-dotierte Zinnoxidschicht, die ebenfalls flammpyrolytisch durch Hydrolyse von Zinn- und Fluorverbindungen herstellbar ist.

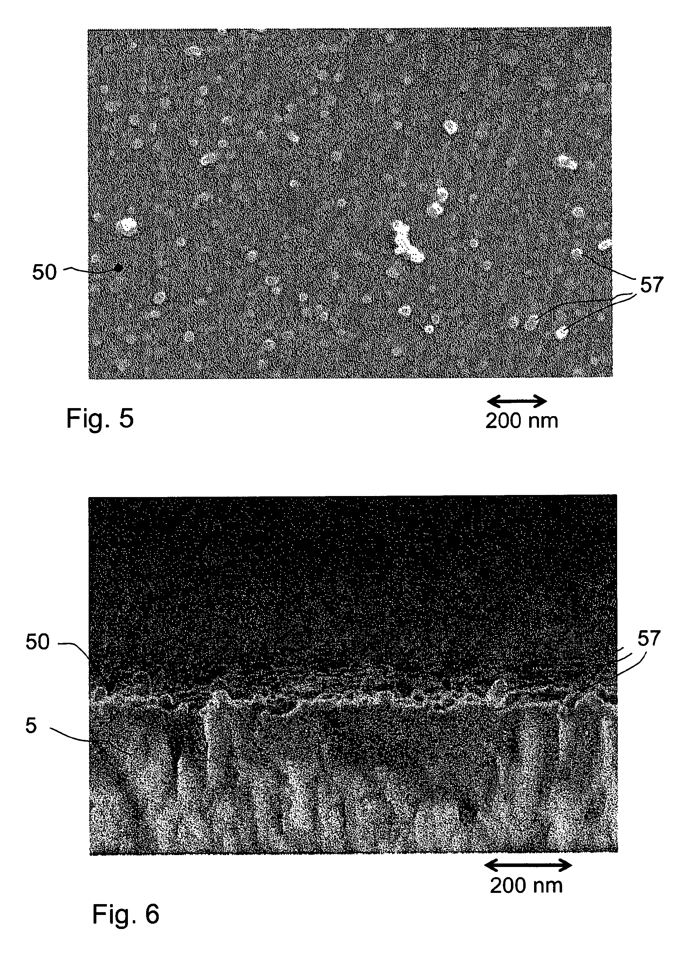

Gemäß einem weiteren Ausführungsbeispiel wird auf der flammpyrolytischen Schicht 5 eine hydrophobe Beschichtung aufgebracht. Dazu wird bei dem in Fig. 5 dargestellten Ausführungsbeispiel ein Silikat-haltiges Sol-Gel mit einer hydrophoben Komponente aufgebracht, welches dann eine hydrophobe Schicht 15 bildet. Bevorzugt wird als hydrophobe Komponente ein Fluoralkylsilan verwendet, welches dem Sol-Gel beigemischt wird. Neben der Barrierewirkung wird außerdem durch die flammpyrolytische Schicht 5 eine vorzügliche Haftungsverbesserung der hydrophoben Sol-Gel-Schicht bewirkt, so daß diese Schichten besonders haltbar sind. Geeignet ist ein derartiges Schichtsystem beispielsweise, um einem erfindungsgemäßen Gegenstand schmutzabweisende Eigenschaften und damit eine leichte Reinigbarkeit zu verleihen.

Anstelle oder zusätzlich zur hydrophoben Schicht 15 und/oder der ITO-Schicht 13 können auch andere funktionelle Schichten aufgebracht werden. Beispielsweise kann eine infrarotreflektierende Zinnoxidschicht, oder eine harte Kratzschutzschicht, Interferenzschichten, wie beispielsweise eine Antireflexbeschichtung, eine Verspiegelungsschicht, eine photokatalytisch wirksame Schicht -beispielsweise eine Titanoxid-haltige Schicht und/oder eine farbgebende Schicht aufgebracht werden.

Fig. 3 zeigt ein weiteres Ausführungsbeispiel mit mehrlagiger flammpyrolytischer Schicht 5. Bei diesem Ausführungsbeispiel ist eine flammpyrolytische Schicht 5 mit Lagen 51 - 56 durch sequentielles Überstreichen mit Flammen abgeschieden worden, denen abwechselnd verschiedene metallhaltige Verbindungen zugesetzt wurden. Die so erzeugte Wechselschicht kann unter anderem als InterferenzSchichtsystem wirken und auf diese Weise verspiegelnd, entspiegelnd und/oder farbgebend wirken. Beispielsweise können dazu sequentiell silikathaltige Lagen und Titanoxidhaltige Lagen durch Zusatz von Silan und Titanchlorid flammpyrolytisch hergestellt werden.

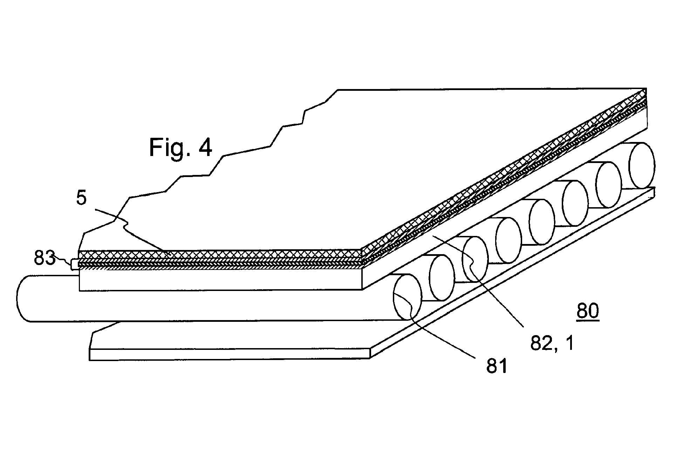

Fig. 4 zeigt eine solarthermische Solaranlage 80 mit einem erfindungsgemäß beschichteten Solarglas 82 als Substrat 1. Die Solaranlage 80 weist Kollektorröhren 81 auf, welche vom Solarglas 82 abgedeckt sind. Das Solarglas 82 weist eine mehrlagige Entspiegelungsschicht 83 auf, um Reflexionsverluste zu erniedrigen. Um diese Schicht 83 vor eine langfristigen Degradation zu schützen, ist diese Schicht 83 auf dem Substrat 1 mit einer erfindungsgemäß flammpyrolytisch abgeschiedenen Siliziumoxid-haltigen Schicht 5 abgedeckt.

Selbstverständlich kann, anders als in der vereinfachten Darstellung der Fig. 4 das Solarglas 83 auch beidseitig mit einer Entspiegelungsschicht und einer flammpyrolytischen Barriereschicht versehen werden.

In weiterer Ausgestaltung kann wie anhand von Fig. 4 beschrieben, auch noch eine hydrophobe Beschichtung aufgebracht werden. Bevorzugt wird dazu eine auf der flammpyrolytischen Schicht 5 infolge der Anbindung an die oberflächlichen Hydroxylgruppen der Schicht 5 besonders gut haftende Silikat-haltige und mit Fluoralkylsilan dotierte Sol-Gel-Schicht mit auf der flammpyrolytischen Schicht 5 aufgebracht.

In den Fig. 5 und 6 sind rasterelelektronische Aufnahmen von einem mit einer flammpyrolytisch abgeschiedenen Schicht beschichteten Glaskeramik-Substrat dargestellt. Dabei zeigt Fig. 5 die beschichtete Oberfläche in Aufsicht und Fig. 6 eine Aufnahme einer Bruchkante des beschichteten Substrats. Die Vergrößerung dieser Aufnahmen ist anhand der unter den Bildern gezeigten Maßstabsbalken zu entnehmen. Die in Fig. 5 gezeigte Aufsicht auf die Oberfläche der flammpyrolytischen Schicht wurde mit einer Beschleunigungsspannung von 5 kV mit 200000-facher Vergrößerung aufgenommen. Das in Fig. 6 gezeigte Bild wurde mit 300000-facher Vergrößerung ebenfalls mit einer Beschleunigungsspannung von 5 kV aufgenommen.

Beide Bilder zeigen, daß die Oberfläche 50 der flammpyrolytischen Schicht 5 insgesamt eine körnige Struktur mit Siliziumoxid-haltigen Körnern 57 aufweist. Von den in den Aufnahmen erkennbaren Körnern weisen mehr als 90 % einen Durchmesser kleiner als 80 Nanometer, sogar kleiner als 60 Mikrometer, überwiegend bis 40 Nanometer auf. Aufgrund dieser feinkörnigen Schichtstruktur wird eine besonders große Oberfläche mit optisch aufgrund der geringen Größe der Körner nicht auffälliger Struktur erzielt. Die große Oberfläche in Verbindung mit den an der Oberfläche der Siliziumoxid-haltigen Schicht 5 zumindest in frisch abgeschiedenem Zustand in hoher Dichte vorhandenen OH-Gruppen sorgt für eine besonders gute Haftung nachfolgend aufgebrachter Materialien, wie etwa weiteren Schichten.

Es ist dem Fachmann ersichtlich, dass die Erfindung nicht auf die vorstehend beschriebenen Ausführungsformen beschränkt ist, sondern vielmehr in vielfältiger Weise variiert werden kann. Insbesondere können die Merkmale der einzelnen beispielhaften Ausführungsformen auch miteinander kombiniert werden.

## Patentansprüche

1. Solarglas-Scheibe mit einem Substrat und einer auf dem Substrat angeordneten Barrierebeschichtung und einer Antireflex-Schicht, wobei die Barrierebeschichtung eine flammpyrolytisch aufgebrachte Metalloxid-haltige Schicht umfaßt.

2. Solarglas-Scheibe gemäß Anspruch 1, **dadurch gekennzeichnet, daß** die Antireflex-Schicht auf der Barrierebeschichtung aufgebracht ist.

3. Solarglas-Scheibegemäß Anspruch 1, **dadurch gekennzeichnet, daß** die flammpyrolytisch aufgebrachte Schicht silikathaltig ist.

4. Solarglas-Scheibegemäß Anspruch 1 oder 2, **dadurch gekennzeichnet, daß** die flammpyrolytisch aufgebrachte Schicht ein Oxid zumindest eines der Metalle Titan, Aluminium, Zirkonium, Zinn, Indium enthält.

5. Solarglas-Scheibegemäß einem der vorstehenden Ansprüche, **gekennzeichnet durch** eine flammpyrolytisch aufgebrachte, Mischoxid-haltige Schicht.

6. Solarglas-Scheibegemäß einem der vorstehenden Ansprüche, **gekennzeichnet durch** eine mehrlagige flammpyrolytisch aufgebrachte Schicht.

7. Solarglas-Scheibegemäß einem der vorstehenden Ansprüche, **gekennzeichnet durch** eine flammpyrolytisch aufgebrachte Gradientenschicht.

8. Solarglas-Scheibegemäß einem der vorstehenden Ansprüche, **dadurch gekennzeichnet, daß** die flammpyrolytisch aufgebrachte Schicht OH-Gruppen enthält.

9. Solarglas-Scheibegemäß einem der vorstehenden Ansprüche, **dadurch gekennzeichnet, daß** die flammpyrolytisch aufgebrachte Schicht eine Schichtdicke von 1 bis 100 Nanometern, bevorzugt 4 bis 40 Nanometern, besonders bevorzugt höchstens 35 Nanometern aufweist.

10. Solarglas-Scheibegemäß einem der vorstehenden Ansprüche, **gekennzeichnet durch** ein Kalknatronglas-Substrat.

11. Solarglas-Scheibegemäß einem der vorstehenden Ansprüche, **dadurch gekennzeichnet, daß** die flammpyrolytisch aufgebrachte Schicht ein leitendes oder halbleitendes Oxid enthält.

12. Solarglas-Scheibegemäß einem der vorstehenden Ansprüche, **dadurch gekennzeichnet, daß** das Substrat mit einer hydrophoben Beschichtung beschichtet ist.

13. Verfahren zur Herstellung einer Solarglas-Scheibe mit einer Barrierebeschichtung auf einem Substrat, insbesondere gemäß einem der vorstehenden Ansprüche, bei welchem zumindest ein Bereich der Oberfläche des Substrats mit einer Flamme überstrichen und eine metalloxidhaltige Schicht mittels Hydrolyse einer metallhaltigen Verbindung in der Flamme abgeschieden wird, während die Flamme den Bereich des Substrats überstreicht und wobei auf die Barrierebeschichtung eine Antireflex-Schicht aufgebracht wird.

14. Verfahren gemäß Anspruch 13, **dadurch gekennzeichnet, daß** eine silikathaltige Schicht durch Hydrolyse einer Siliziumverbindung in der Flamme abgeschieden wird.

15. Verfahren gemäß Anspruch 14, **dadurch gekennzeichnet, daß** als Siliziumverbindung zumindest eine der Substanzen
- Hexamethyldisiloxan (HMDSO),
- Hexamethyldisilazan (HMDSN),
- Tetramethoxysilan,
- Tetraethoxysilan
verwendet wird.
